# EUROPEAN PATENT APPLICATION

(11) **EP 3 564 014 A1**
(43) Date of publication of application: **06.11.2019**
(21) Application number: 18208777.5
(22) Date of filing: 28.11.2018
(51) Int. Cl.: B29C 64/314, B29C 64/227, B29C 64/25, B29C 64/255, B33Y 30/00, B33Y 40/00, B01F 7/00

(54) **THREE-DIMENSIONAL PRINTER INCLUDING A STIRRING ELEMENT**

(30) Priority: 02.05.2018 CN 201810409734
(71) Applicant: XYZprinting, Inc., New Taipei City 22201 (TW); Kinpo Electronics, Inc., New Taipei City 22201 (TW)
(72) Inventor: LEE, An-Hsiu, 22201 New Taipei City (TW); HUANG, Chen-Fu, 22201 New Taipei City (TW); LIN, Tsai-Yi, 22201 New Taipei City (TW)
(74) Representative: Emde, Eric

(57) **Abstract**

A 3D printer including a machine platform, a container, at least one stirring element and a driving module is provided. The container is assembled to the machine platform and is adapted to contain a liquid forming material. The stirring element has a rotating shaft and is adapted to rotate along the rotating shaft. The driving module is connected to at least one of the container and the at least one stirring element, so as to drive the container and the at least one stirring element to produce relative movement when 3D printing is not performed, and the liquid forming material in the container is stirred by the at least one stirring element.

## Description

### BACKGROUND

### Technical Field

The disclosure relates to a three-dimensional (3D) printer.

### Description of Related Art

Along with progress of Computer-Aided Manufacturing (CAM), the manufacturing industry has developed a Rapid Prototyping (RP) technique capable of quickly producing an original design prototype. The RP technique has no limitation in geometric shape, and the more complex a printed part is, the more superior the technique demonstrates, and the RP technique may greatly save manpower and processing time, and in terms of a requirement of the shortest time, a design part on 3D CAD is truly presented, which is not only touchable, but its geometric curve may be truly felt, and assemblability of the part may be tested, and even possible functional test may be carried out.

Photopolymer is a liquid forming material commonly used by most of 3D printers, and techniques such as StereoLithography Apparatus (SLA), Digital Light Processing (DLP), Continuous Liquid Interface Production (CLIP), etc. all take the liquid forming material, for example, the photopolymer as a printing material.

Taking a pull-up SLA technique as an example, after a platform is moved into a container from top to bottom to contact the liquid forming material, a curing light source under the container provides light to penetrate through the container to cure the liquid forming material located between the platform and the container into a forming layer, and then the forming layer is peeled off from the bottom of the container, such that the forming layer is attached to the platform, thereafter, the forming layers are stacked on the platform layer-by-layer to construct a 3D object.

However, during a curing process, the energy of the curing light is continuously accumulated in the photopolymer, and even the photopolymer that is not supposed to be cured into the forming layer is still influenced by an energy accumulation effect to produce qualitative change, and along with the lapse of time, this part of the photopolymer still has a chance to be cured. Even if this part of the photopolymer is not substantially cured, along with a change in physical property and chemical property caused by the qualitative change, a subsequent 3D printing process is probably affected. Therefore, how to maintain the photopolymer in the container to meet the physical property and chemical property required by the 3D printing to avoid occurrence of curing during the 3D printing process or between the 3D printing processes is a problem to be resolved by related technicians of the field.

### SUMMARY

The disclosure is directed to a three-dimensional (3D) printer, in which by configuring a stirring element and driving the stirring element to move relative to a container, a liquid forming material in the container is stirred by the stirring element.

An embodiment of the disclosure provides a 3D printer including a machine platform, a container, at least one stirring element and a driving module. The container is assembled to the machine platform and is adapted to contain a liquid forming material. The stirring element has a rotating shaft and is adapted to rotate along the rotating shaft. The driving module is connected to at least one of the container and the at least one stirring element, so as to drive the container and the at least one stirring element to produce relative movement when 3D printing is not performed, and the liquid forming material in the container is stirred by the at least one stirring element.

Based on the above description, in the 3D printer, by configuring the stirring element, and driving the stirring element to move relative to the container so that the liquid forming material in the container is stirred by a stirring effect produced from the stirring element. Therefore, when the 3D printing is not performed, an accumulation effect of light energy in the liquid forming material is avoided through the relative movement between the container and the stirring element, so as to maintain a physical property and a chemical property of the liquid forming material required by the 3D printing.

In order to make the aforementioned and other features and advantages of the disclosure comprehensible, several exemplary embodiments accompanied with figures are described in detail below.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.
FIG. 1 is a schematic diagram of a three-dimensional (3D) printer according to an embodiment of the disclosure.
FIG. 2 is a schematic diagram of the 3D printer of FIG. 1 in another status.
FIG. 3 and FIG. 4 are respectively top views of a 3D printer in different statuses.
FIG. 5 is a schematic diagram of an electrical connection of related components of a 3D printer.
FIG. 6 is a schematic diagram of a stirring element.
FIG. 7 is a partial top view of a 3D printer in a different status according to another embodiment of the disclosure.
FIG. 8 and FIG. 9 are partial top views of a 3D printer according to different embodiments of the disclosure.

### DESCRIPTION OF EMBODIMENTS

Reference will now be made in detail to the present preferred embodiments of the disclosure, examples of which are illustrated in the accompanying drawings. Wherever possible, the same reference numbers are used in the drawings and the description to refer to the same or like parts.

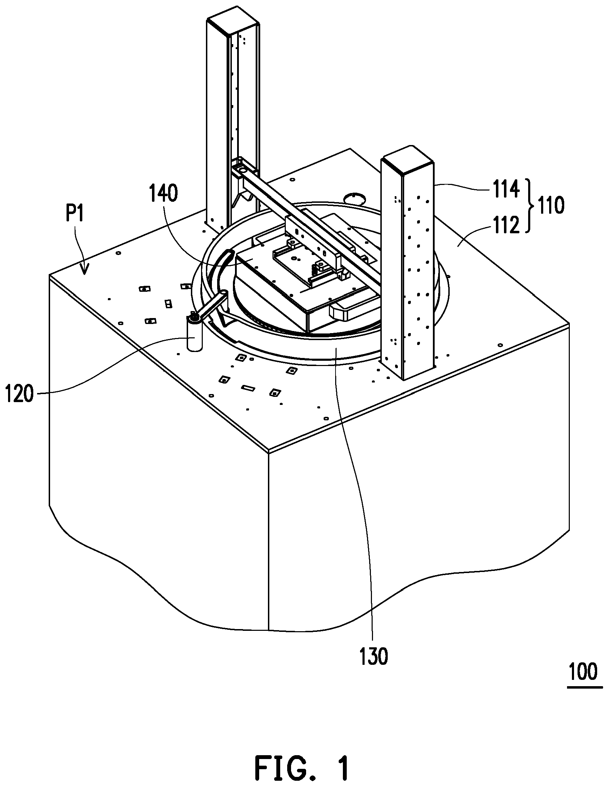

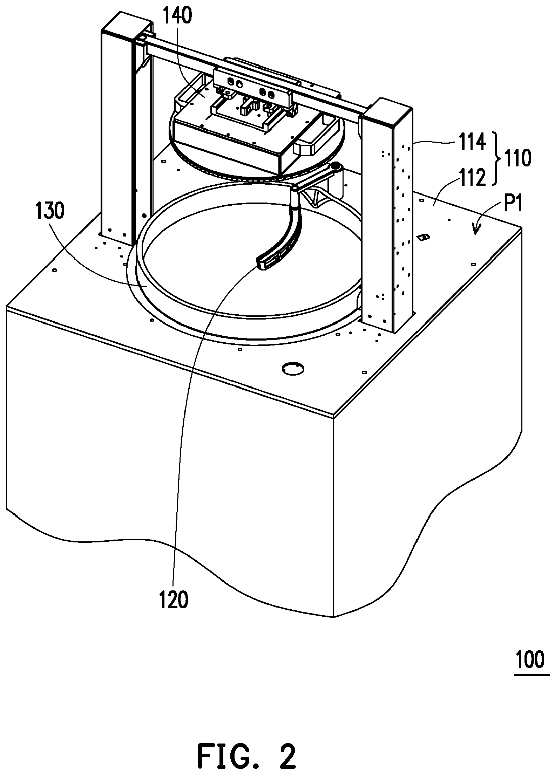

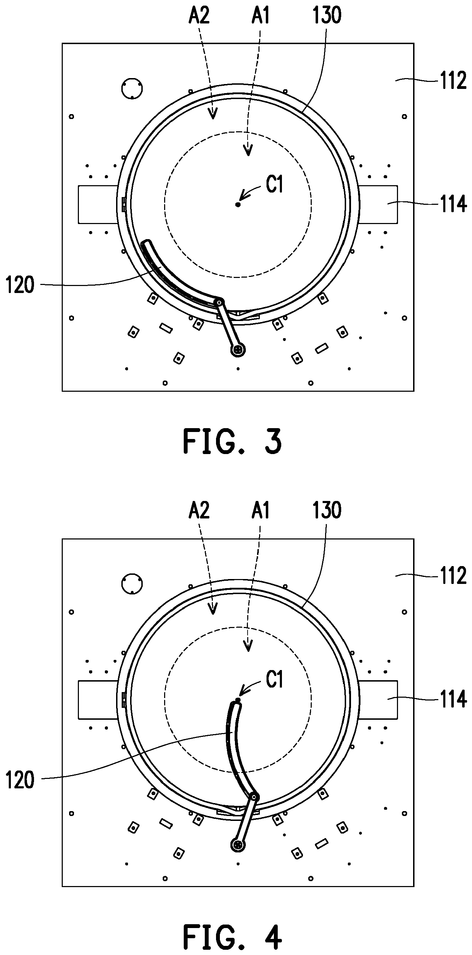

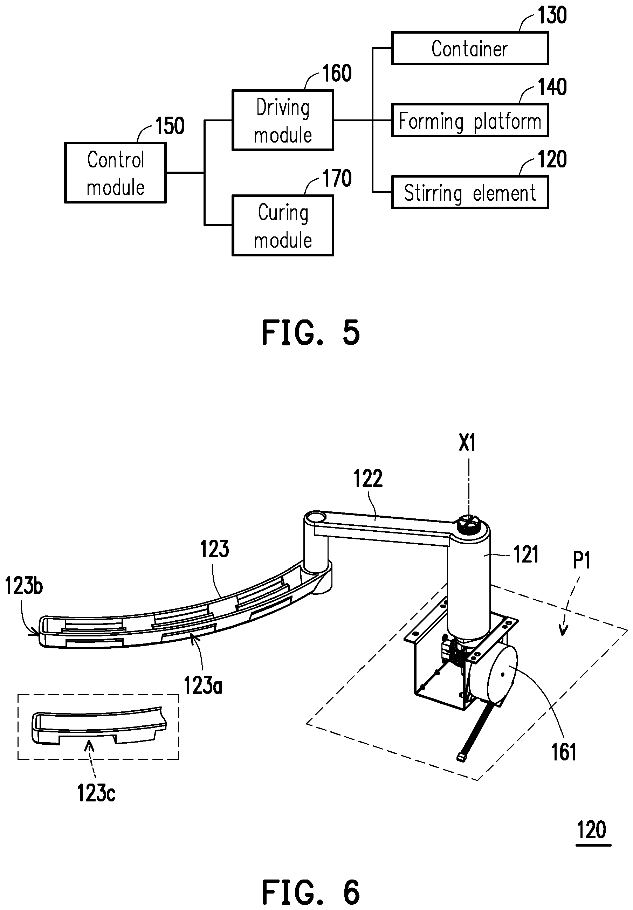

FIG. 1 is a schematic diagram of a three-dimensional (3D) printer according to an embodiment of the disclosure. FIG. 2 is a schematic diagram of the 3D printer of FIG. 1 in another status. FIG. 3 and FIG. 4 are respectively top views of the 3D printer in different statuses. FIG. 5 is a schematic diagram of an electrical connection of related components of the 3D printer. Referring to FIG. 1 and FIG. 5, in the embodiment, the 3D printer 100 is, for example, a StereoLithography Apparatus (SLA) including a machine platform 110, a stirring element 120, a container 130, a forming platform 140, a control module 150, a driving module 160 and a curing module 170, where the machine platform 110 includes a base 112 and a gantry 114 erected thereon, the driving module 160 includes a lifting mechanism disposed in the gantry 114, and the forming platform 140 is assembled to the lifting mechanism and is adapted to be driven to move in or move out of the container 130. The driving module 160 further includes a rotating mechanism disposed in the base 112, and the container 130 is assembled to the rotating mechanism and is adapted to be driven to rotate relative to the base 112. The curing module 170 is, for example, an ultraviolet light source disposed in the base 112. The control module 150 is electrically connected to the driving module 160 and the curing module 170 to control rotation of the container 130, ascending or descending of the forming platform 140 and curing of a liquid forming material (not shown) in the container 130 through the curing module 170, so as to achieve related operations required by 3D printing. Those skilled in the art may learn details of the lifting mechanism, the rotating mechanism and the curing operation, etc., from existing techniques, which are not repeated.

Referring to FIG. 1 to FIG. 4, the stirring element 120 is disposed on the base 112 of the machine platform 110 and is connected to the driving module 160, and the control module 150 may drive the stirring element 120 to switch between different statuses through the driving module 160. It should be noted that the top view of FIG. 3 corresponds to the status shown in FIG. 1, and the top view of FIG. 4 corresponds to the status shown in FIG. 2, and in FIG. 3 and FIG. 4, the gantry 114 and the forming platform 140 are omitted for easy recognition of related components. In the embodiment, the container 130 is further divided into a forming area A1 and a non-forming area A2, which are separated by a contour of an orthogonal projection of the forming platform 140 onto a bottom surface of the container 130, where when the 3D printing is performed, the stirring element 120 is stay in the non-forming area A2, and when the 3D printing is not performed, the stirring element 120 is driven to move to the forming area A1 (which is actually extended from the non-forming area A2 to the forming area A1), and the driving module 160 drives the container 130 to rotate, such that the stirring element 120 may produce a stirring effect to the liquid forming material in the container 130. In other words, when the 3D printing is not performed, the liquid forming material is stirred by the stirring element 120 through the relative movement between the container and the stirring element, which may effectively mitigate the accumulation effect of light energy in the liquid forming material, so as to maintain a physical property and a chemical property of the liquid forming material required by the 3D printing.

FIG. 6 is a schematic diagram of the stirring element. Referring to FIG. 6 in comparison with FIG. 3 and FIG. 4, in the embodiment, the stirring element 120 has a rotating shaft 121, an extending arm 122 and a stirring arm 123, where the rotating shaft 121 is pivotally connected to a plane P1 of the base 112, the stirring arm 123 is located in the container 130, and the extending arm 122 is connected between the rotating shaft 121 and the stirring arm 123, and extends from the outside of the container 130 to the inside of the container 130. The driving module 160 is connected to the rotating shaft 121 through a motor 161 disposed under the plane PI, and is adapted to drive the rotating shaft 121 to rotate about an axis XI, so as to cause a position change of the stirring element 120 as that shown in FIG. 3 and FIG. 4.

A mode of producing the relative movement between the container 130 and the stirring element 120 is not limited by the disclosure. In the embodiment, since the driving module 160 is respectively connected to the container 130 and the stirring element 120, three modes of relative movement are included, and the first mode is as that described above, where when the 3D printing is not performed, the stirring element 120 is driven to move to the forming area A1, and then the stirring element 120 is maintained stationary but the container 130 is rotated, so as to produce relative movement there between. The second mode is that when the 3D printing is not performed, the container 130 is maintained stationary but the stirring element 120 is driven to swing back and forth within the container 130 to produce relative movement there between. The third mode is that when the 3D printing is not performed, the driving module 160 drives the container 130 to rotate, and also drives the stirring element 120 to switch back and forth, so as to produce relative movement there between.

Moreover, in another embodiment that is not shown, the stirring element 120 is pivotally connected to the plane PI of the base 112 only through the rotation shaft 121, though the driving module 160 does not use the motor 161 to drive the stirring element 120. Namely, in this case, the stirring element 120 is adapted to be driven by an external force to change a position, for example, when the 3D printing is not performed, a user exerts a force to push the stirring element 120 to move from the position shown in FIG. 3 to the position shown in FIG. 4, then, as described in the first mode, the stirring element 120 is maintained stationary, and the container 130 is rotated to produce the relative movement there between.

Referring to the embodiment of FIG. 4 and FIG. 6, in the embodiment, the stirring arm 123 of the stirring element 120 further has a stirring structure used for increasing a contact area between the stirring arm 123 and the liquid forming material, and improving a stirring degree of the stirring arm 123 on the liquid forming material during the process of relative movement. The stirring structure includes openings 123a, a tooth structure 123c or a combination thereof. Moreover, the stirring element 120 and the container 130 move relative to each other, in order to improve a stirring range of the stirring element 120 on the liquid forming material, in the embodiment, when the 3D printing is not performed, an end 123b of the stirring arm 123 located away from the extending arm 122 is moved to a center C1 of the container 130, and the center C1 may be regarded as a rotating center of the container 130. In this way, when the container 130 is driven to rotate, a moving range of the stirring arm 123 relative to the container 130 may include the entire bottom of the container 130, namely, the liquid forming material in the container 130 may all be stirred by the stirring arm 123. Moreover, once stirring of the liquid forming material is completed to carry on the 3D printing, since a contour of the stirring arm 123 is matched with a contour of a side edge of the container 130, it represents that an extending direction of the stirring arm 123 is also matched with a rotating direction of the container 130, and the stirring element 123 may be smoothly and closely received at the side edge of the container 130, so as to avoid structural interference with the forming platform 140.

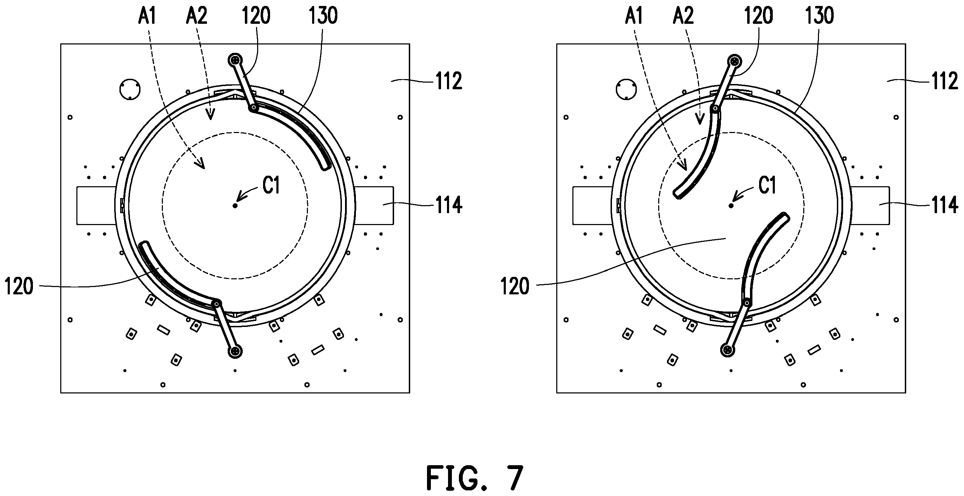

FIG. 7 is a partial top view of the 3D printer in a different status according to another embodiment of the disclosure. Referring to FIG. 7, in the present embodiment, the 3D printer includes a pair of stirring elements 120 located at two opposite sides of the container 130. Structural features of the stirring elements 120 are as that described above, and are also adapted to the aforementioned three modes, especially the second mode, and through back and forth swing of the pair of stirring elements 120, a provided stirring effect is superior to the stirring effect of the single stirring element 120.

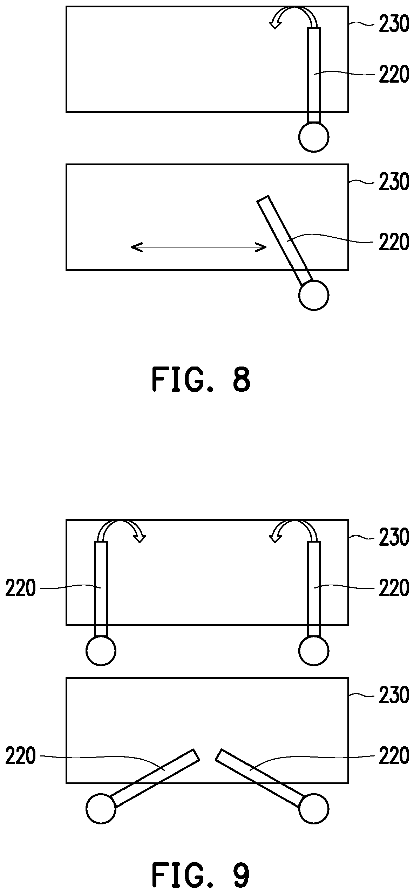

FIG. 8 and FIG. 9 are partial top views of the 3D printer according to different embodiments of the disclosure. Referring to FIG. 8 first, in the embodiment, the stirring element 220 is rotatably disposed in the container 230, and the driving module is connected to the container 230 and drives the container 230 to move linearly, and now the stirring element 220 may be changed between a portrait state and an oblique state as shown in FIG. 8 through an external force or the driving module, i.e. the stirring element 220 is rotated relative to the container 230 to change a position, and when the 3D printing is not performed, the driving module drives the container 230 to linearly move back and forth to also achieve the effect of stirring the liquid forming material.

Moreover, the driving module may also be connected to the stirring element 220, and drives the stirring element 220 to rotate relative to the container 230 to achieve the aforementioned requirement of position change. Moreover, the driving module may also be respectively connected to the container 230 and the stirring element 220, and while the container 230 is driven to linearly move back and forth, the stirring element 230 is also driven to rotate or swing back and forth in the container 230, which may also achieve the effect of stirring the liquid forming material.

Referring to FIG. 9, in the embodiment, the 3D printer includes a pair of stirring elements 220 disposed in the container 230 in parallel and located at a same side of the container 230. Similar to the embodiment of FIG. 8, the container 230 and the stirring elements 220 also have the same three modes, so as to smoothly provide the required stirring effect to the liquid forming material in the container 230.

In summary, in the aforementioned embodiments, by configuring the stirring element in the 3D printer, and driving the stirring element to move relative to the container, the liquid forming material in the container is stirred by a stirring effect produced from the stirring element smoothly. Moreover, the relative movement includes modes of fixing the container and rotating the stirring element, fixing the stirring element and rotating the container and simultaneously rotating the container and the stirring element, etc., which may all achieve the effect of stirring the liquid forming material. In addition, the stirring element has a stirring structure to increase the contact area with the liquid forming material, which may also improve the stirring effect in case of the relative movement. Therefore, through the relative movement between the container and the stirring element when the 3D printing is not performed, light energy accumulation effect of the liquid forming material is avoided, so as to maintain a physical property and a chemical property of the liquid forming material required by the 3D printing.

## Claims

1. A three-dimensional printer (100), comprising:
a machine platform (110);
a container (130, 230), assembled to the machine platform (110), and adapted to contain a liquid forming material;
at least one stirring element (120, 220), having a rotating shaft (121), and adapted to rotate along the rotating shaft (121); and
a driving module (160), connected to at least one of the container (130, 230) and the at least one stirring element (120, 220), so as to drive at least one of the container (130, 230) and the at least one stirring element (120, 220) to produce a relative movement when three-dimensional printing is not performed so that the liquid forming material in the container (130, 230) is stirred by the at least one stirring element (120, 220).

2. The three-dimensional printer (100) as claimed in claim 1, wherein the driving module (160) is connected to the container (130, 230) to drive the container (130, 230) to rotate relative to the machine platform (110), and the at least one stirring element (120, 220) is driven by an external force to rotate, and move relative to the container (130, 230).

3. The three-dimensional printer (100) as claimed in claim 1, wherein the driving module (160) is connected to the container (130, 230) to drive the container (130, 230) to move relative to the machine platform (110), and the at least one stirring element (120, 220) is driven by an external force to rotate and move relative to the container (130, 230).

4. The three-dimensional printer (100) as claimed in claim 1, wherein the driving module (160) is connected to the at least one stirring element (120, 220) to drive the at least one stirring element (120, 220) to rotate and move relative to the container (130, 230).

5. The three-dimensional printer (100) as claimed in claim 1, wherein the driving module (160) is connected to the container (130, 230) and the at least one stirring element (120, 220) to respectively drive the container (130, 230) and the at least one stirring element (120, 220) to rotate relative to the machine platform (110).

6. The three-dimensional printer (100) as claimed in claim 1, wherein the driving module (160) is connected to the container (130, 230) and the at least one stirring element (120, 220), wherein the driving module (160) drives the container (130, 230) to move relative to the machine platform (110), and drives the at least one stirring element (120, 220) to rotate and move relative to the container (130, 230).

7. The three-dimensional printer (100) as claimed in claim 1, wherein the at least one stirring element (120, 220) has an extending arm (122) and a stirring arm (123), the rotating shaft (121) is pivotally connected to the machine platform (110), the stirring arm (123) is located in the container (130, 230), and the extending arm (122) is connected between the rotating shaft (121) and the stirring arm (123), and extends from outside of the container (130, 230) to inside of the container (130, 230).

8. The three-dimensional printer (100) as claimed in claim 7, wherein the stirring arm (123) has a stirring structure used for increasing a contact area between the stirring arm (123) and the liquid forming material, and improving a stirring degree of the stirring arm (123) on the liquid forming material.

9. The three-dimensional printer (100) as claimed in claim 8, wherein the stirring structure comprises at least one opening (123a), a tooth structure (123c) or a combination thereof.

10. The three-dimensional printer (100) as claimed in claim 7, wherein a contour of the stirring arm (123) is matched with a contour of a side edge of the container (130, 230).

11. The three-dimensional printer (100) as claimed in claim 7, wherein when the container (130, 230) and the at least one stirring element (120, 220) have the relative movement, a moving range of the stirring arm (123) relative to the container (130, 230) comprises an entire bottom of the container (130, 230).

12. The three-dimensional printer (100) as claimed in claim 7, wherein when the container (130, 230) and the at least one stirring element (120, 220) have the relative movement, an end of the stirring arm (123) located away from the extending arm (122) is located at a center (CI) of the container (130, 230).

13. The three-dimensional printer (100) as claimed in claim 1, wherein the container (130, 230) has a forming area (A1) and a non-forming area (A2), and when the three-dimensional printing is performed, the at least one stirring element (120, 220) is located in the non-forming area (A2), and when the three-dimensional printing is not performed, the at least one stirring element (120, 220) is located in the forming area (A1).

14. The three-dimensional printer (100) as claimed in claim 1, wherein the three-dimensional printer (100) comprises a pair of stirring elements (120, 220) located at two opposite sides of the container (130, 230).

15. The three-dimensional printer (100) as claimed in claim 1, wherein the three-dimensional printer (100) comprises a pair of stirring elements (120, 220) located at a same side of the container in parallel (130, 230).
